# EUROPÄISCHE PATENTSCHRIFT

(11) **EP 1 295 402 B1**
(45) Veröffentlichungstag und Bekanntmachung des Hinweises auf die Patenterteilung: **17.08.2005**
(21) Anmeldenummer: 01945259.8
(22) Anmeldetag: 06.06.2001
(51) Int. Cl.: H04B 1/18, H04B 1/52, H04B 1/40

(54) **ANORDNUNG ZUM BETRIEB MEHRERER ENDGERÄTE**
ARRANGEMENT FOR OPERATING VARIOUS TERMINAL DEVICES
AGENCEMENT POUR FAIRE FONCTIONNER PLUSIEURS TERMINAUX

(30) Priorität: 09.06.2000 DE 10028189; 06.06.2001 DE 20109370 U
(43) Veröffentlichungstag der Anmeldung: 26.03.2003
(73) Patentinhaber: DaimlerChrysler AG, 70567 Stuttgart (DE)
(72) Erfinder: LUY, Johann-Friedrich, 89073 Ulm (DE); MÜLLER, Thomas, 89075 Ulm (DE); MAYER, Stephan, 89180 Bühlenhausen (DE); REICHERT, Günter, 71563 Affalterbach (DE)
(86) Internationale Anmeldenummer: PCT/EP2001/006400
(87) Internationale Veröffentlichungsnummer: WO 2001/095507

(56) Entgegenhaltungen:
- EP-A- 0 503 151
- EP-A- 0 567 766
- GB-A- 2 281 663
- US-A- 5 239 688

## Beschreibung

Die Erfindung bezieht sich auf eine Anordnung zum Betrieb mehrerer Mobilfunk-Endgeräte an einer gemeinsamen Antenne.

Üblicherweise nimmt die Anzahl von Endgeräten für die mobile Kommunikation auch in Fahrzeugen, wie z. B. im Bus, im Automobil, zu. Dabei werden neben dem Einsatz zur Übermittlung von Sprache diese Endgeräte (auch Mobilfunkgeräte genannt) immer häufiger für die Datenübertragung in Telematik- oder Notrufsystemen eingesetzt.

Sowohl aus optischen Gründen als auch aus Platz- und Kostengründen kann für eine Vielzahl von Endgeräten die erforderliche Anzahl von Antennen am Fahrzeug nicht beliebig erhöht werden.

Aus der DE-A-195 47 288 A1 ist eine Funkstation mit einer abgesetzten Antenneneinheit bekannt, wobei ein Duplexer antennennah zugeordnet ist. Darüber hinaus wird ebenfalls antennennah ein Vorverstärker angeordnet. Diese Antenneneinheit ist mit der Sende- und Empfangsantenne als integrierte Einheit ausgebildet und steht über zwei gesonderte, voneinander getrennte Sende- und Empfangszweige mit unidirektionalen Sende- bzw. Empfangseinheiten in Verbindung.

US 5 239 688 offenbart eine Anordnung zum Anschluß mehrerer Geräte an eine gemeinsame Antenne unter Verwendung von Filtern.

Aus der US-A-4 228 544 ist eine Sende- und Empfangseinheit für Fahrzeuge mit einer Sende- und Empfangsantenne bekannt, bei der der Fußpunkt der Sende- und Empfangsantenne mit einer in unmittelbarer Nähe der Sende- und Empfangsantenne angebrachten Antennenweiche verbunden ist. Ein mit der Antennenweiche verbundener Vorverstärker wird ebenfalls in unmittelbarer Nähe des Antennenfußes angeordnet.

Eine erste Hauptaufgabe der Erfindung ist es daher, eine Anordnung zum Betrieb mehrerer Endgeräte an einer gemeinsamen Antenne anzugeben, welche einen besonders einfachen Aufbau aufweist und eine möglichst rückwirkungsfreie Kommunikation bei einer gleichzeitigen Minimierung des Verkabelungsaufwands ermöglicht. Da durch die Verwendung einer gemeinsamen Antenne, deren Aufbauort sich zudem abgesetzt (d.h. in größerer Entfernung) von den jeweiligen Endgeräten befindet, stellt die Minimierung des notwendigen Verkabelungsaufwands bei der Zusammenführung der Endgeräte auf eine einzige Antenne ein wesentliches Element im Rahmen der Aufgabenstellung dar.

Diese erste Hauptaufgabe wird durch die im Anspruch 1 definierte Anordnung gelöst. Hierbei bilden besonders vorteilhaft das erste und das zweite Trennelement funktional als auch räumlich eine Einheit. Auf diese weise läßt sich gewinnbringend dieses Koppelnetzwerk kompakt gestalten und in Abhängigkeit der vorgegebenen Umgebungsgeometrie an einer zur Installation der erfindungsgemäßen Anordnung am besten geeigneten Stelle anbringen. Besonders vorteilhaft wirkt sich die Tatsache, dass das Koppelnetzwerk funktional weder der Antenne noch einem der Endgeräte zugeordnet ist, in der Einschaft aus, dass die drei wesentlichen Teilkomponenten der erfinderischen Anordnung, das sind die Antenne, das Koppelnetzwerk und die Endgeräte, völlig unabhängig voneinander, optimal positioniert werden können.

Mit der erfindungsgemäßen Anordnung wird in besonders vorteilhafter Weise die Möglichkeit geschaffen bidirektional arbeitende Endgeräte, d.h. Endgeräte welche in der Lage sind Informationen zu senden als auch zu empfangen, miteinander zu koppeln. Hierzu müssen in einem Trennelement (10) die von den Endgeräten kommenden bidirektionalen Leitungen in Sende- und Empfangszweige getrennt werden, um anschließend alle den Endgeräten zuzuordnenden Sende- und Empfangszweige jeweils vorzugsweise mittels Summierer zusammenzuführen. Nach der Zusammenführung können sodann umgehend die beiden getrennten Sende- und Empfangszweige durch das Trennelement (8) wieder zusammengeführt werden. So entsteht wiederum eine bidirektionale Leitung zur Antenne, auf welcher nun aber alle Signale der einzelnen Endgeräte gemeinsam geführt werden. Auf die Weise der erfinderischen Ausgestaltung des Koppelelementes wird gewinnbringend eine kompakte Ausführungsform der erfinderischen Anordnung realisierbar, die sich in ihrer Funktionalität und Anwendbarkeit deutlich von dem im Stand der Technik bekannten abhebt. So zielt hierzu im Gegensatz beispielsweise die aus DE 19547288 bekannte Anordnung eben gerade daraufhin ab, die beiden Trennelement nicht in einer kompakten, variabel anordenbaren Einheit zu integrieren, sondern geradezu möglichst weiträumig voneinander anzuordnen, so daß die getrennten Sende- und Empfangszweige möglichst lange unabhängig voneinander geführt werden können. Eine solche Anordnung wäre, insbesondere bei der Anwendung im Kraftfahrzeug, aus ökonomischen nachteilhaft, da sie in zusätzlichem Verkabelungsaufwand resultiert.

Nach einem ersten erfindungsgemäßen Lösungsansatz der ersten Ausführungsform befindet sich das Koppelnetzwerk zwischen der Antenne und den Mobilfunkgeräte, z.B. im Kofferraum eines Fahrzeugs neben den Mobilfunkgeräten.

Nach einem zweiten erfindungsgemäßen Lösungsansatz der ersten Ausführungsform ist das Koppelnetzwerk Bestandteil eines Mobilfunkgerätes, das mindestens einen zusätzlichen Aus-/Eingang für ein oder mehrere Mobilfunkgeräte aufweist. Des weiteren ist es selbstverständlich auch denkbar entsprechend das Koppelnetzwerk bei oder in der Antenne als selbständige Einheit zu integrieren oder aber in ein anderes Gerät (beispielsweise ein Steuergerät für andere Fahrzeugkomponenten) als Einheit einzubringen. Durch eine vorteilhafte Integration in ein bereits an Bord des Fahrzeugs vorhandenes Gerät wird es gewinnbringend möglich darin bereits vorhandene elektrische Komponenten, wie beispielsweise Netzgeräte, für die Verwendung durch Komponenten das Koppelnetzwerkes mit zu verwenden.
Das Koppelnetzwerk der ersten Ausführungsform umfaßt als einen vorteilhaften Aspekt der Erfindung zusätzlich Verstärker, Teiler und/oder Summierer.

Die Erfindung gemäß der ersten Ausführungsform geht dabei von der Überlegung aus, daß in einem abgeschlossenen Raum mehrere Endgeräte für eine mobile Kommunikation über eine einzelne Antenne betrieben werden sollten. Damit eine Rückwirkung des einen Endgerätes auf benachbarte Endgeräte vermieden wird, sind bevorzugt erste Trennelemente zur Trennung von gesendeter und empfangener Leistung an der Antenne vorgesehen. Durch diese ersten Trennelemente ist gewährleistet, daß zum einen Sende- und Empfangswellen antennenseitig getrennt werden. Zum anderen werden durch zweite Trennelemente die Sende- und Empfangswellen des jeweiligen Endgerätes voneinander getrennt, wobei die Kombination oder die Trennung der Sende- bzw. Empfangswellen von verschiedenen Endgeräten getrennt voneinander erfolgt. Hierdurch läßt sich eine Rückwirkung eines sendenden Endgerätes auf ein benachbartes Endgerät besonders sicher vermeiden. Darüber hinaus wird der Aufwand für die Installation zusätzlicher Antennen für mehrere Endgeräte, insbesondere Mobilfunk-Endgeräte, erheblich reduziert.

Zweckmäßigerweise ist als Trennelement ein Zirkulator oder ein Richtkoppler vorgesehen. Bei dem Zirkulator handelt es sich um ein zyklisch aufgebautes n-Tor, beispielsweise ein 3-Tor, bei dem Signale eines Tores jeweils nur zu dem im Umlaufsinn nächsten Tor gelangen. Somit erfolgt mit Hilfe des Zirkulators eine Trennung von Sende- und Empfangssignal. Zirkulatoren bzw. Richtkoppler werden insbesondere im Zeit-Duplex-Betrieb (auch time division duplex standard genannt, kurz TDD) oder aber auch im Frequenz-Duplex-Betrieb (auch frequency division duplex standard genannt, kurz FDD) als Trennelement verwendet.

Zur Trennung von Sende- und Empfangssignal bei einer Kommunikation im Frequenz-Duplex-Betrieb (auch frequency division duplex standard genannt, kurz FDD), z. B. beim GSM-Netz (GSM=Global System for Mobile Communication), ist vorzugsweise als Trennelement ein Filter, insbesondere ein Duplex-Filter, vorgesehen. Das Duplex-Filter dient dabei der Trennung der Vorwärts- und Rückwärtsrichtung, d.h. der Sende- und Empfangsrichtung. Das Duplex-Filter umfaßt einen bidirektionalen Anschluß und zwei unidirektionale Anschlüsse, die dem jeweils entsprechenden Frequenzband zugeordnet sind.

Zur Aufteilung des von der gemeinsamen Antenne empfangenen Frequenzbandes auf die Endgeräte ist in zweckmäßiger weise empfangsseitig ein Teiler vorgesehen. Zur Ausstrahlung der Sendesignale der Endgeräte über die gemeinsame Antenne ist sendeseitig ein Summierer vorgesehen. Zur Kompensation der Verluste der Sende- oder Empfangssignale ist vorzugsweise im Sende- und im Empfangszweig mindestens je ein Verstärkerelement vorgesehen. Dabei ist das Verstärkerelement bevorzugt zwischen dem ersten und dem zweiten Trennelement angeordnet. Bevorzugtermaßen ist der Antenne empfangsseitig ein eigenes Verstärkerelement zugeordnet. Je nach Art und Ausführung der Anordnung sowie in Abhängigkeit von der Kommunikationsart ist vorzugsweise sendeseitig allen Endgeräten ein Verstärkerelement gemeinsam zugeordnet. Alternativ oder zusätzlich kann sendeseitig und/oder empfangsseitig den einzelnen Endgeräten ein eigenes Verstärkerelement zugeordnet sein.

Eine zweite Hauptaufgabe der Erfindung besteht darin, eine Anordnung zum Betrieb mehrerer Endgeräte an einer gemeinsamen Sendeantenne und an einer von der gemeinsamen Sendeantenne getrennten gemeinsamen Empfangsantenne bereitzustellen, welche einen besonders einfachen Aufbau aufweist und eine möglichst rückwirkungsfreie Kommunikation ermöglicht. Im Rahmen dieser zweiten Aufgabe besteht eine besondere Aufgabe der Erfindung in der Minimierung des Verkabelungsaufwands, insbesondere dann, wenn viele Endgeräte betrieben werden.

Diese zweite Aufgabe wird gemäß einer zweiten Ausführungsform der Erfindung durch eine Anordnung zum Betrieb mehrerer Endgeräte an einer Sendeantenne und einer Empfangsantenne mit einem Koppelnetzwerk gelöst, welches ein dem jeweiligen Endgerät zugeordnetes zweites Trennelement umfaßt.

Nach einem ersten erfindungsgemäßen Lösungsansatz der zweiten Ausführungsform befindet sich das Koppelnetzwerk zwischen der Antenne und den Mobilfunkgeräten, z.B. im Kofferraum eines Fahrzeugs neben den Mobilfunkgeräten.

Nach einem zweiten erfindungsgemäßen Lösungsansatz der zweiten Ausführungsform ist das Koppelnetzwerk als Bestandteil eines Mobilfunkgerätes ausgebildet, das mindestens einen zusätzlichen Aus-/Eingang für ein oder mehrere Mobilfunkgeräte aufweist.

Nach einem dritten Lösungsansatz der zweiten Ausführungsform ist das Koppelnetzwerk in der Nähe der Sendeantenne und/oder der Empfangsantenne angeordnet, oder in eine bzw. beide Antennen räumlich integriert. Eine weitere vorteilhafte Ausgestaltung ergibt sich durch die Integration des Koppelnetzwerkes in ein bereits im Fahrzeug vorhandenes Gerät, gewinnbringend unter Ausnutzung dort bereits vorhandener Komponenten, wie beispielsweise dem Netzgerät.

Das Koppelnetzwerk der zweiten Ausführungsform umfaßt ebenfalls zusätzlich Verstärker, Teiler und/oder Summierer.

Die Erfindung gemäß der zweiten Ausführungsform geht dabei von der Überlegung aus, daß in einem abgeschlossenen Raum mehrere Endgeräte für eine mobile Kommunikation über jeweilige getrennte Sende- und Empfangsantennen betrieben werden sollten. Damit eine Rückwirkung des einen Endgerätes auf benachbarte Endgeräte vermieden wird, sind bevorzugt Trennelemente zur Trennung von gesendeter und empfangener Leistung endgeräteseitig vorgesehen.

Durch die Trennelemente werden die Sende- und Empfangswellen des jeweiligen Endgerätes voneinander getrennt, wobei die Kombination oder die Trennung der Sende- bzw. Empfangswellen von verschiedenen Endgeräten getrennt voneinander erfolgt. Hierdurch läßt sich eine Rückwirkung eines sendenden Endgerätes auf ein benachbartes Endgerät besonders sicher vermeiden. Darüber hinaus wird der Aufwand für die Installation zusätzlicher Antennen für mehrere Endgeräte, insbesondere Mobilfunk-Endgeräte, erheblich reduziert.

Zweckmäßigerweise wird wie in der ersten Ausführungsform als Trennelement ein Zirkulator oder ein Richtkoppler vorgesehen. Bei dem Zirkulator handelt es sich um ein zyklisch aufgebautes n-Tor, beispielsweise ein 3-Tor, bei dem Signale eines Tores jeweils nur zu dem im Umlaufsinn nächsten Tor gelangen. Somit erfolgt mit Hilfe des Zirkulators eine Trennung von Sende- und Empfangssignal. Zirkulatoren bzw. Richtkoppler werden insbesondere im Zeit-Duplex-Betrieb (auch time division duplex standard genannt, kurz TDD) oder aber auch im Frequenz-Duplex-Betrieb (auch frequency division duplex standard genannt, kurz FDD) als Trennelement verwendet.

Zur Trennung von Sende- und Empfangssignal bei einer Kommunikation im Frequenz-Duplex-Betrieb (auch frequency division duplex standard genannt, kurz FDD), z. B. beim GSM-Netz (GSM=Global System for Mobile Communication), ist vorzugsweise als Trennelement ein Filter, insbesondere ein Duplex-Filter, vorzugsweise endgeräteseitig vorgesehen. Das Duplex-Filter dient dabei der Trennung der Vorwärts- und Rückwärtsrichtung, d.h. der Sende- und Empfangsrichtung. Das Duplex-Filter umfaßt einen bidirektionalen Anschluß und zwei unidirektionale Anschlüsse, die dem jeweils entsprechenden Frequenzband zugeordnet sind.

Zur Ausstrahlung der Sendesignale der Endgeräte über die gemeinsame Antenne ist sendeseitig ein Summierer vorgesehen. Zur Kompensation der Verluste der Sende- oder Empfangssignale kann gewinnbringend mindestens je ein Verstärkerelement vorgesehen werden. Bevorzugtermaßen sind den Antennen empfangsseitig und/oder sendeseitig ein eigenes Verstärkerelement zugeordnet. Je nach Art und Ausführung der Anordnung sowie in Abhängigkeit von der Kommunikationsart wird vorzugsweise sendeseitig und/oder empfangsseitig allen Endgeräten jeweils ein Verstärkerelement zugeordnet.

Ausführungsbeispiele der Erfindung werden anhand einer Zeichnung näher erläutert. Darin zeigen:
Fig. 1 schematisch eine Anordnung zum Betrieb mehrerer Endgeräte an einer gemeinsamen Antenne mit einem Koppelnetzwerk gemäß der ersten Ausführungsform der Erfindung,
Fig. 2 schematisch ein Koppelnetzwerk gemäß Figur 1,
Fig. 3 schematisch eine alternative Ausführung der ersten Ausführungsform des Koppelnetzwerks gemäß Figur 1,
Fig. 4 ein Diagramm mit der Übertragungsfunktion eines Duplex-Filters für das GSM-Netz gemäß der ersten Ausführungsform der Erfindung,
Fig. 5 ein Diagramm mit den Blocking-Anforderungen für das GSM-Netz,
Fig. 6 schematisch eine Anordnung zum Betrieb mehrerer Endgeräte an einer gemeinsamen Sendeantenne und einer gemeinsamen Empfangsantenne mit einem Koppelnetzwerk gemäß der zweiten Ausführungsform der Erfindung,
Fig. 7 schematisch das Koppelnetzwerk gemäß Figur 6,
Fig. 8 schematisch eine alternative Ausführung der zweiten Ausführungsform des Koppelnetzwerks gemäß Figur 6,
Fig. 9 schematisch eine weitere alternative Ausführung der zweiten Ausführungsform des Koppelnetzwerks gemäß Figur 6,

Einander entsprechende Teile sind in allen Figuren mit den gleichen Bezugszeichen versehen.

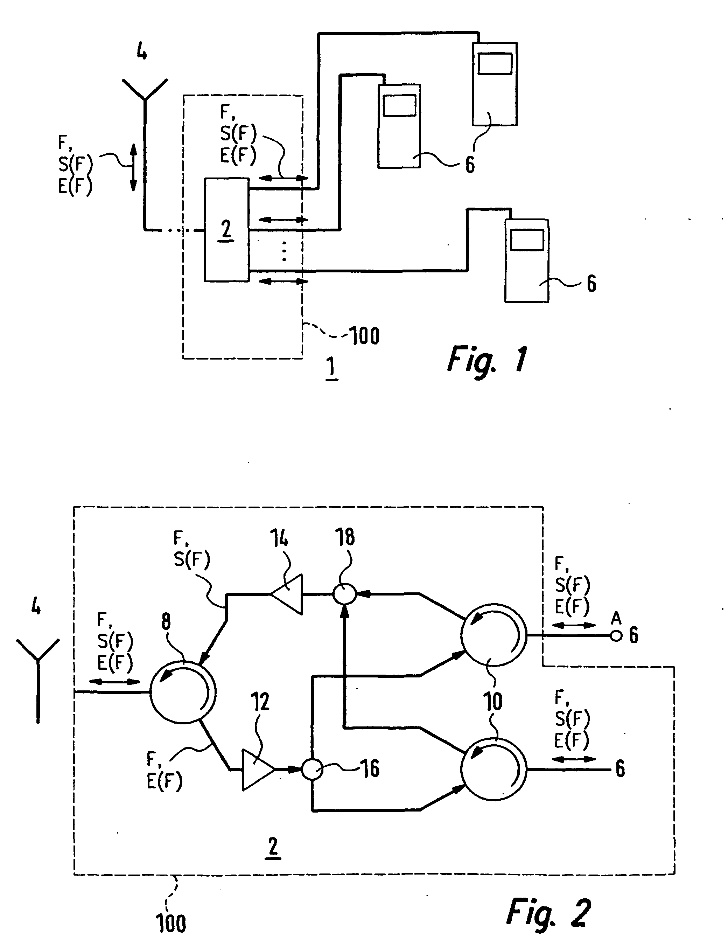

In Figur 1 ist eine Anordnung 1 mit einem Koppelnetzwerk 2 zur Aufteilung von über eine Antenne 4 empfangenen Signalen E mit einer Frequenz F auf die Endgeräte 6, z. B. mobile Funk-Endgeräte, dargestellt. Alternativ oder zusätzlich dient das Koppelnetzwerk 2 der Bündelung von gesendeten Signalen S der Endgeräte 6. Das Koppelnetzwerk 2 wird nach einem ersten Lösungsansatz der ersten Ausführungsform, wie durch die gestrichelte Linie 100 der Fig. 1 angedeutet, als kompakte Einheit zwischen der Antenne und den Endgeräten angeordnet.

Nach einem zweiten erfindungsgemäßen Lösungsansatz der ersten Ausführungsform wird das Koppelnetzwerk 2 als Bestandteil eines Endgeräts integriert, das mindestens einen zusätzlichen Aus-/Eingang für den Anschluß weiterer Mobilfunkgeräte aufweist.
Eine dritte Möglichkeit der Unterbringung des Koppelnetzwerks besteht darin, dass es direkt in oder nahe bei der Antenne integriert wird, oder aber daß es zusätzliche Einheit in ein von der Sende- und Empfangsmimik unabhängiges Gerät (zum Beispiel ein Motor-Steuergerät) integriert wird.

In Figur 2 ist schematisch eine Ausführung des Koppelnetzwerks 2 gemäß Figur 1 dargestellt, welches sich insbesondere für ein Zeit-Duplex-Netz TDD oder Frequenz-Duplex-Netz FDD eignet. Das Koppelnetzwerk 2 umfaßt ein der Antenne 4 zugeordnetes erstes Trennelement 8 sowie eine der Anzahl der Endgeräte 6 entsprechende Anzahl von zweiten Trennelementen 10, die den Endgeräten 6 zugeordnet sind. Als erstes und zweites Trennelement 8 bzw. 10 sind bevorzugt Zirkulatoren vorgesehen, die einen besonders einfachen Aufbau aufweisen und rückwirkungsfrei ausgebildet sind. Alternativ können Richtkoppler verwendet werden.

Das komplette Koppelnetzwerk 2 der Fig. 2 kann vorteilhaft, wie durch die gestrichelte Linie 100 angedeutet, in einem der mobilen Endgeräte 6 (Basisendgerät) integriert werden. Dabei wird mindesten ein Ein-/Ausgang A des Basisendgeräts für den Anschluß weiterer mobiler Endgeräte bereitgestellt. Selbstverständlich kann die Anzahl der Ein-/Ausgänge variieren. Zur Kompensation von Verlusten wird im Koppelnetzwerk 2 empfangsseitig der Antenne 4 ein erstes Verstärkerelement 12 zugeordnet. Sendeseitig ist den Endgeräten 6 zur Kompensation von Verlusten ein gemeinsames zweites Verstärkerelement 14 zugeordnet. Zur Aufteilung der von der Antenne 4 empfangenen Signale E mit der Frequenz F auf die Endgeräte 6 ist nach dem ersten Trennelement 8 ein Teiler 16 angeordnet. Zur Bündelung und Übertragung der Sendesignale S mit der Frequenz F der Endgeräte 6 über die gemeinsame Antenne 4 ist sendeseitig zwischen dem ersten und dem zweiten Trennelement 8 bzw. 10 ein Summierer 18 vorgesehen.

Im Betrieb "Empfang" der Anordnung 1 wird ein empfangenes Signal E(F) nach der gemeinsamen Antenne 4 vom ersten Trennelement 8 vom Sendesignal S(F) getrennt und mittels des Teilers 16 auf die zweiten Trennelemente 10, z. B. Zirkulatoren, aufgeteilt. Die zweiten Trennelemente 10 leiten das empfangene Signal E(F) gleichmäßig an das betreffende Endgerät 6, z.B. ein Mobilfunk-Endgeräte, weiter. Der Verlust beim Empfang des Signals E(F) wird durch das Verstärkerelement 12 kompensiert.

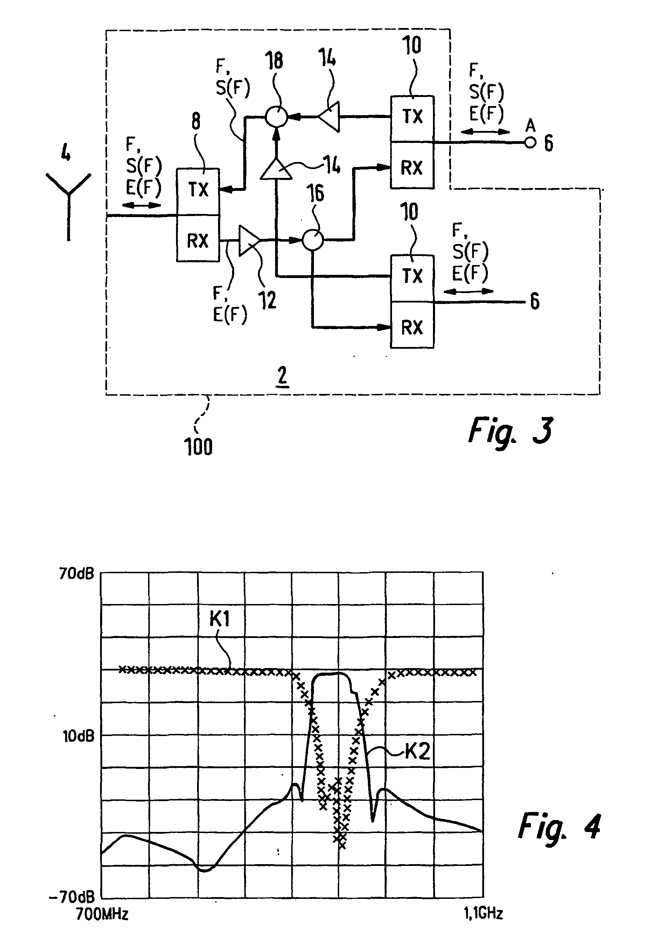

Im Sendefall eines oder mehrerer der Endgeräte 6 wird der wesentliche Teil der Leistung vom zugeordneten zweiten Trennelement 10 über den Summierer 18 an das erste Trennelement 8 und von diesem auf die gemeinsame Antenne 4 geleitet. Der Leistungsverlust beim Senden wird durch das Verstärkerelement 14 kompensiert. Selbstverständlich ist es im Bedarfsfall gewinnbringend auch möglich über diese Leistungsverluste hinaus zu verstärken, um die über die Antenne 4 abgestrahlte Leistung insgesamt zu erhöhen. Darüber hinaus dienen die Verstärkerelemente 12 und 14 der Verbesserung der Entkopplung der Endgeräte 6 voneinander.
Je nach Auslegung des Koppelnetzwerkes können die Verstärkerelemente 14 bzw. 12 alternativ oder zusätzlich auch zwischen den zweiten Trennelementen 120 und dem Summierer 18 bzw. dem Teiler 16 liegen, wobei dann für jeden Endgerätezweig ein Sende- (14) und/oder Empfangsverstärkelement (12) notwendig wird.
Bei einer Kommunikation im Frequenz-Duplex-Betrieb, z.B. GSM, umfaßt das Koppelnetzwerk 2, wie in Figur 3 schematisch dargestellt, vorzugsweise anstelle von Zirkulatoren als Trennelemente 8 bzw. 10 auch Filter, insbesondere Duplex-Filter. Duplex-Filter werden für GSM-Endgeräte 6 in großer Stückzahl hergestellt und sind daher besonders preiswerte Bauelemente, die Sende- und Empfangskanäle voneinander trennen. Alternativ können als Trennelemente 8 bzw. 10 andere elektronische Bauelemente mit gleicher Funktionalität verwendet werden. Alternativ können im Frequenz-Duplex-Betrieb anstelle der Filter auch Zirkulatoren oder Richtkoppler verwendet werden.

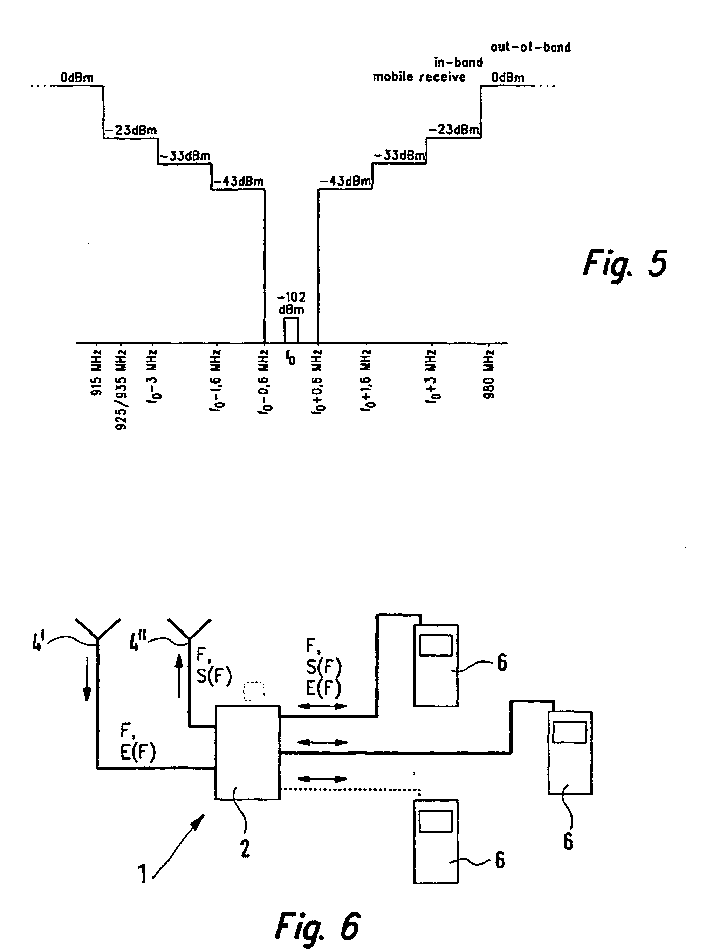

Beim Empfangen wird das empfangene Signal E(F) vom Verstärkerelement 12 verstärkt und mittels des Teilers 16 auf die beiden als Duplex-Filter ausgeführten Trennelemente 10 und somit auf die Endgeräte 6 aufgeteilt. Im Sendefall findet nach den Trennelementen 10 eine getrennte Verstärkung für jedes Endgerät 6 mittels der Verstärkerelemente 14 statt, um eine bessere Entkopplung der Endgeräte 6 zu gewährleisten und die Verluste in den Filtern der Trennelemente 10 zu kompensieren. D.h. jedes Endgerät 6 weist sendeseitig im entsprechenden Kanal ein zugeordnetes Verstärkerelement 14 auf. Somit ist bei einer GSM-Kommunikation sendeseitig eine der Anzahl der Endgeräte 6 entsprechende Anzahl Verstärkerelementen 14 vorgesehen.
Je nach Auslegung des Netzwerks können, wie zuvor, die Verstärkerelemente 12 bzw. 14 alternativ oder zusätzlich auch zwischen dem ersten Trennelement 8 und dem Summierer 18 bzw. zwischen den zweiten Trennelementen 10 und dem Teiler 16 angeordnet sein, wobei in den Endgerätezweigen jeweils ein Sende- 14 und/oder Enpfangsverstärkerelement 12 benötigt wird.
Alternativ zum Aufbau als separates Gerät zwischen Antenne (4) und den Endgeräten (6) kann das komplette Koppelnetzwerk 2 wie in Fig. 3 durch die gestrichelte Linie 100 angedeutet, in vorteilhafter Weise einem der mobilen Endgeräte 6 (Basisendgerät) integriert werden. Dabei wird der Ein-/Ausgang A des Basisendgeräts für weitere mobile Endgeräte bereitgestellt. Selbstverständlich kann wie in der Ausführung der Fig. 2 die Anzahl der Ein-/Ausgänge variieren.
Wie bei Fig. 2 bereits ausgeführt, so kann auch das Koppelnetzwerk nach Fig. 3 in/bei der Antenne oder in einem beliebigen anderen Gerät mit untergebracht werden.
Über das erste Trennelement 8 (=Sendefilter) wird das mittels des Summierers 18 aus den Sendesignalen S der Endgeräte 6 gebündelte Sendesignal S an die Antenne 4 ausgegeben und abgestrahlt. Figur 4 zeigt beispielhaft die Übertragungsfunktionen eines Duplex-Filters der Firma Murata für GSM. Es zeigt, daß eine Unterdrückung von etwa 40dB für den jeweils anderen Kanal erreicht wird (Kanal K1 gegenüber Kanal K2)
Die Anforderungen an das Duplex- oder Koppelfilter ergeben sich aus den GSM-Spezifikationen, beispielsweise sind in Figur 5 die Blocking-Anforderungen grafisch dargestellt. Aus der Sendeleistung von GSM errechnet sich daraus eine nötige Kanalunterdrückung von 36dB.

Die mit der Erfindung gemäß der ersten Ausführungsform der Figuren 1-5 erzielten Vorteile bestehen insbesondere darin, daß mittels des Koppelnetzwerks 2 die Anordnung 1 zum Betrieb mehrerer Endgeräte 6 an einer einzigen gemeinsamen Antenne 4 geeignet ist. Darüber hinaus wird durch die Anordnung des Koppelnetzwerks 2 in der Nähe der Endgeräte der Verkabelungsaufwand minimiert, da die der Anzahl der Endgeräte entsprechende Vervielfachung der Verkabelung erst auf der relativ kurzen Strecke zwischen Koppelnetzwerk und Endgerät entsteht. Durch die Verwendung von Zirkulatoren bzw. Filtern als Trennelemente 8 und 10 werden ein- und auslaufende Wellen voneinander getrennt, so daß eine rückwirkungsfreie Kommunikation mehrerer Endgeräte 6 besonders einfach und sicher ermöglicht ist. Insbesondere wird die Bündelung oder die Aufteilung der Sendesignale S bzw. der Empfangssignale E der bzw. auf die verschiedenen Endgeräte 6 getrennt voneinander ausgeführt, d.h. für über die einzelne gemeinsame Antenne 4 auslaufende und einlaufende Wellen erfolgt eine getrennte Summation bzw. Aufteilung. Darüber hinaus können im Bedarfsfall in vorteilhafter Weise die Sende- und Empfangssignale S bzw. E getrennt voneinander für ein- und auslaufende Welle verstärkt werden, wodurch eine besonders gute Entkopplung gegeben ist. Durch eine geeignete Dimensionierung der Komponenten dieser Anordnung ist diese für alle momentan in Betrieb befindlichen und geplanten zukünftige Mobilfunk-Standards einsetzbar. Darüber hinaus kann die Anordnung für den Betrieb eines oder gleichzeitig mehrerer terrestrischer oder satellitengestützter Mobilfunk-Standards (GSM 900, GSM 1800, AmPS, PDC, CDMA, UMTS, ICO, Globalstar, ...) ausgelegt werden. Dazu müssen in gewinnbringender Weise vor allem die Verstärker, die Trennelemente und die Summierer/Teiler auf die jeweils gewünschte Frequenzbereiche abgestimmt werden.

Unter Bezugnahme auf die Figuren 6-9 wird nunmehr eine zweite Ausführungsform der Erfindung erläutert.

In der Fig. 6 ist wiederum die Anordnung 1 mit einem Koppelnetzwerk 2 zur Aufteilung von über eine separate Empfangsantenne 4' empfangenen Signalen E mit einer Frequenz F auf die Endgeräte 6 dargestellt. Alternativ oder zusätzlich dient das Koppelnetzwerk 2 der Bündelung von gesendeten Signalen S der Endgeräte 6. Das Koppelnetzwerk 2 dient in der zweiten Ausführungsform dazu, die von den Endgeräten 6 erzeugten zu sendenden Signale S in eine separate Sendeantenne 4" einzukoppeln. Wie in der ersten Ausführungsform, kann sich das Koppelnetzwerk als separates Gerät zwischen der Antenne und den Mobilfunkgeräten befinden. Alternativ dazu kann das Koppelnetzwerk auch als Bestandteil eines Mobilfunkgerätes ausgebildet sein, wobei dieses mindestens einen zusätzlichen Aus-/Eingang für ein oder mehrere Mobilfunkgeräte aufweist. Gemäß der zweiten Ausführungsform kann das Koppelnetzwerk 2 auch in der Nähe oder als funktional unabhängiges Element in der Sendeantenne 4" und/oder der Empfangsantenne 4' angeordnet werden, oder aber auch als Bestandteil eines unabhängigen Gerätes.

Gemäß der zweiten Ausführungsform der Fig. 6 ist es möglich Funkdienste, die im Zeitmultiplex oder im Frequenzmultiplex senden und empfangen (z. B. UMTS-TDD) einzusetzen. Die nötige Dämpfung zwischen dem Sende- und Empfangspfad geschieht durch die Freiraumdämpfung zwischen den beiden Antennen 4' und 4", die vorteilhaft in ausreichender Entfernung zueinander positioniert werden. Es ist in vorteilhafter Weise jedoch auch denkbar die beiden Antennen durch schaltungstechnische Maßnahmen voneinander zu trennen. So wäre es für diesem Fall denkbar, Teile des Signals aus dem Sendezweig auszukoppeln und in Abhängigkeit der Position der Antennen zueinander in den Empfangszweig zeitverzögert einzukoppeln. Durch geeignete Zeitverschiebung (Phasenshift um 180°) ergibt hierdurch sich eine Auslöschung des direkt von der Sendeantenne in die Empfangsantenne eingestreuten Signals.

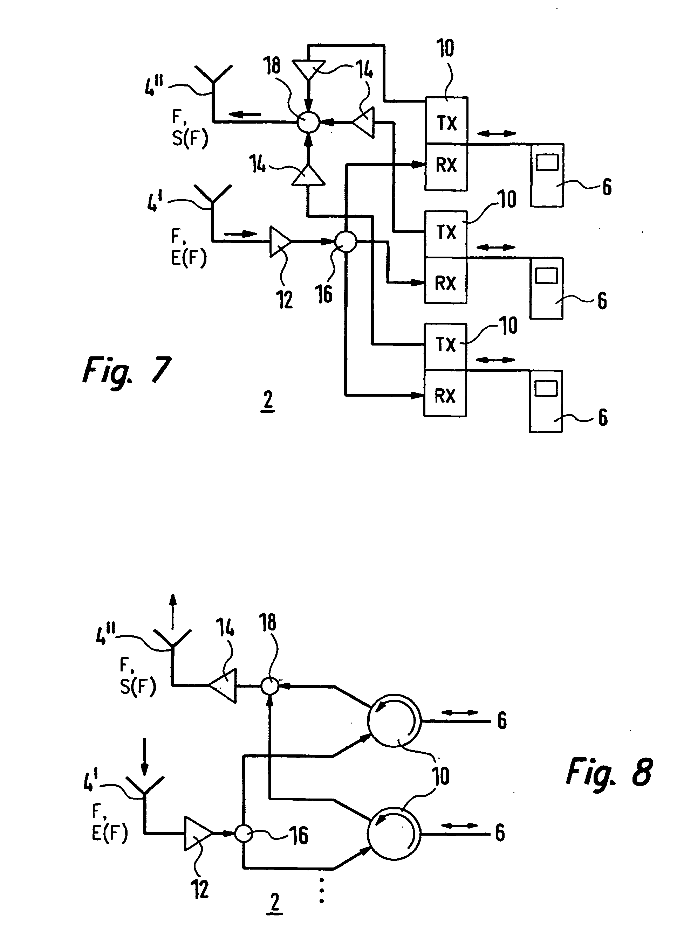

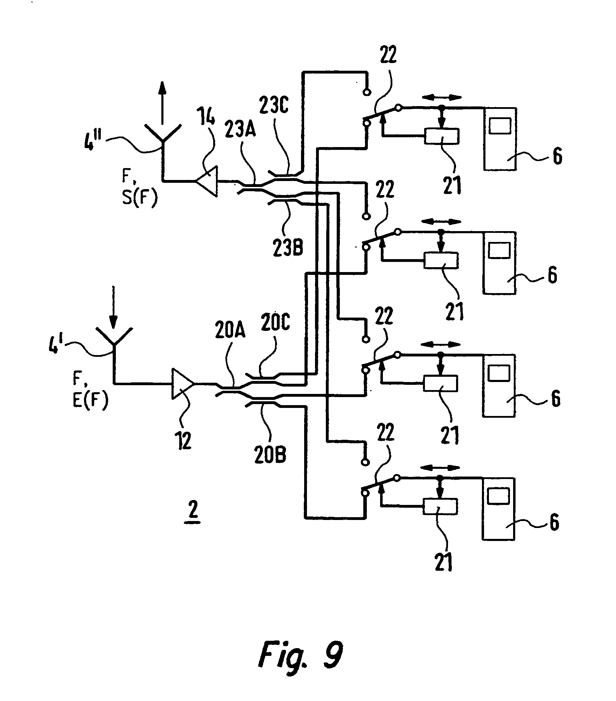

Die Trennung von gesendeter und empfangener Leistung im allgemeinen Fall erfolgt mit Hilfe von Trennelementen, z. B. Zirkulatoren, realisiert werden, wie in der Fig. 8 gezeigt. Für FDD-Standards (Frequenz-Duplex Standards) können die Zirkulatoren durch Sende-/Empfangs-Duplex-Filter, wie in Fig. 7 gezeigt, ersetzt werden. Für TDD- und FDD-Dienste (Zeit- und Frequenz-Duplex Dienste) kann die Trennung gemäß der Anordnung der Fig. 9 auch durch Schalter erfolgen.
Für GSM ergeben sich die Anforderungen bezüglich Leistungsdirektivität für einen störungsfreien Betrieb der Mobiltelefone aus den folgenden den Fachleuten bekannten Standards: ETS 300 577 (GSM Radio transmission and reception) und aus ETS 300 574 (Multiplexing and multiple access on the radio path).

In Fig. 7 ist beispielhaft ein Koppelnetzwerk 2 aufgeführt, dessen Sende- und Empfangspfad an der Seite der Endgeräte mit Hilfe von Sende-/Empfangs-Duplex-Filtern 10 ausgeführt ist. Sendet eines der Endgeräte 6, so wird die Leistung durch das Duplex-Filter 10 an das Verstärkerelement 14 weitergegeben, im Summierer 18 aufsummiert und gelangt so zur Sendeantenne 4". Im Empfangsfall wird das Signal mit Empfangsantenne 4' empfangen und durch das Verstärkerelement 12 verstärkt. Der Teiler 16 teilt das Signal auf die Duplex-Filter 10, 10, 10 auf, die es wiederum an die Endgeräte 6 weitergeben.

Das Koppelnetzwerk 2 der Fig. 8 funktioniert analog zu dem eben dargestellten. Die Signalleistung wird jedoch im Sendefall mit Hilfe der Trennelemente (Zirkulatoren) 10, 10 vom Endgerät 6 an den Summierer 18 weitergegeben, durch das Verstärkerelement 14 verstärkt und von der Sendeantenne 4" abgestrahlt. Im Empfangsfall wird das durch das Verstärkerelement 12 verstärkte Signal an den Teiler 16 geleitet und durch die Trennelemente 10, 10 an die Endgeräte 6 weitergegeben.

Die Richtungstrennung kann sowohl für TDD als auch für FDD wie in Fig. 9 gezeigt, auch durch elektronische Schalter erfolgen. Im Empfangsfall wird das von der Empfangsantenne 4' empfangene Signal durch das Verstärkerelement 12 verstärkt und mit den Kopplerelementen 20A, 20B und 20C an die Endgeräte 6 über entsprechende Schalter 22 weitergegeben. In diesem Modus befindet sich der Schalter 22 in der Stellung "Empfangen". Sendet eines der Endgeräte, so wird die Leistung mit Hilfe eines entsprechenden Leistungsdetektors 21 erkannt, wobei der entsprechende Schalter 22 auf "Senden" umgeschaltet wird, so daß die Sendeleistung über die Kopplerelemente 23A, 23B und 23C an das Verstärkerelement 14 und zur Sendeantenne 4" weitergegeben wird. Ein Übersprechen der Sendeleistung des sendenden Endgerätes 6 auf die anderen Endgeräte 6 wird hierdurch verhindert. Wie in der ersten Ausführungsform so können auch hier die Verstärkerelemente 12 und 14 alternativ oder zusätzlich auch in den Endgerätezweigen zwischen den Kopplern 20/23 und den Schaltern 22 angeordnet sein.

Durch beide Lösungsansätze
- den Betrieb mehrerer Endgeräte an einer gemeinsamen abgesetzten Antenne,
- als auch den Betrieb mehrerer Endgeräte an einer gemeinsamen abgesetzten Sendeantenne und einer gemeinsamen abgesetzten Empfangsantenne,
wird die beiden Anordnungen zugrunde liegende gemeinsame Aufgabe, eine rückkopplungsfreie, in Bezug auf den Verkabelungsaufwand optimierte Zusammenschaltung mehrerer, auch bidirektionaler Endgeräte, zu schaffen in vollem Umfang vorteilhaft Rechnung getragen.

## Patentansprüche

1. Anordnung zum Betrieb einer Mehrzahl von Endgeräten (6) an einer gemeinsamen abgesetzten Antennenanordnung (4, 4', 4'') mit einem Koppelnetzwerk (2), welches ein der Antennenanordnung (4, 4', 4'') zugeordnetes erstes Trennelement (8) und ein dem jeweiligen Endgerät (6) zugeordnetes zweites Trennelement (10) umfaßt,
**dadurch gekennzeichnet,**
**dass** das erste Trennelement (8) und das zweite Trennelement (10) sowohl funktional als auch räumlich eine Einheit bilden und funktional weder mit der Antenne (4) noch mit einem der Endgeräte (6) in Verbindung stehen,
und **dass** wenigstens eines der Trennelemente (10) so ausgeführt ist, dass daran ein einzelner, bidirektionaler von einem Endgerät zu dem Koppelnetzwerk führender Kommunikationspfad angeschlossen werden kann, wobei dieses Trennelement diesen bidirektionalen Kommunikationspfad in im Koppelnetzwerk separat geführte Sende- und Empfangspfade aufspaltet.

2. Anordnung nach Anspruch 1, **dadurch gekennzeichnet, dass** wenigstens eines der Endgeräte (6) ein bidirektional arbeitendes Endgerät zum Senden und Empfangen von Information ist.

3. Anordnung nach einem der Ansprüche 1 oder 2, **dadurch gekennzeichnet, dass** das Koppelnetzwerk (2) als eigenständige Einheit in der Leitung zwischen der Antennenanordnung (4, 4', 4'') und den Endgeräten (6) angeordnet ist.

4. Anordnung nach einem der Ansprüche 1 oder 2, **dadurch gekennzeichnet, dass** das Koppelnetzwerk (2) als eigenständige Einheit in der Antennenanordnung (4, 4', 4'') angeordnet ist.

5. Anordnung nach einem der Ansprüche 1 oder 2, **dadurch gekennzeichnet, dass** das Koppelnetzwerk (2) als eigenständige Einheit in einem von der Anordnung unabhängigen Gerät angeordnet ist.

6. Anordnung nach einem der Ansprüche 1 bis 5, **dadurch gekennzeichnet, dass** das Koppelnetzwerk (2) in einem der Endgeräte (6) integriert ist, welches mindestens einen zusätzlichen Aus-/Eingang (A) für ein oder mehrere weitere Endgeräte (6) aufweist.

7. Anordnung nach einem der Ansprüche 1 bis 6, bei der mindestens ein Verstärkerelement (12, 14) zur Kompensation der Verluste vorgesehen ist.

8. Anordnung nach Anspruch 7, **dadurch gekennzeichnet, dass** mindestens ein Verstärkerelement (12, 14) zwischen dem ersten und dem zweiten Trennelement (8, 10) angeordnet ist.

9. Anordnung nach einem der Ansprüche 7 bis 8, **dadurch gekennzeichnet, dass** empfangsseitig der Antennenanordnung (4, 4', 4'') ein Verstärkerelement (12) zugeordnet ist.

10. Anordnung nach einem der Ansprüche 7 bis 9, bei der sendeseitig allen Endgeräten (6) gemeinsam ein Verstärkerelement (14) zugeordnet ist.

11. Anordnung nach einem der Ansprüche 7 bis 9, bei der sendeseitig den Endgeräten (6) jeweils ein zugehöriges Verstärkerelement (14) zugeordnet ist.

12. Anordnung nach einem der Ansprüche 1 bis 11, bei der als Trennelement (8, 10) ein Zirkulator oder ein Richtkoppler vorgesehen ist.

13. Anordnung nach einem der Ansprüche 1 bis 11, bei der als Trennelement (8, 10) ein Filter, insbesondere ein Duplex-Filter, vorgesehen ist.

14. Anordnung nach einem der Ansprüche 1 bis 11, bei der als Trennelement (8, 10) ein Schalter (22) vorgesehen ist.

15. Anordnung nach einem der Ansprüche 1 bis 14, bei der empfangsseitig zur Aufteilung der Empfangssignale (E) auf die Endgeräte (6) ein Teiler (16) vorgesehen ist und/oder bei der sendeseitig zur Ausstrahlung des Sendesignals (S) ein Summierer (18) vorgesehen ist.

16. Anordnung nach einem der Ansprüche 1 bis 15, **dadurch gekennzeichnet, dass** die Antennenanordnung durch eine einzige gemeinsame Sende-/Empfangsantenne (4) gebildet ist.

17. Anordnung nach einem der Ansprüche 1 bis 15, **dadurch gekennzeichnet, dass** die Antennenanordnung durch eine gemeinsame abgesetzte Sendeantenne (4") und wenigstens eine zusätzliche von der gemeinsamen abgesetzten Sendeantenne (4") getrennten gemeinsamen abgesetzten Empfangsantenne (4') gebildet ist.

18. Anordnung nach Anspruch 17, **dadurch gekennzeichnet, dass** die Antennen (4', 4") räumlich beabstandet bereitgestellt werden, so daß die nötige Dämpfung zwischen dem Sende- und Empfangspfad durch die Freiraumdämpfung zwischen den Antennen (4', 4") erfolgt.

19. Anordnung nach einem der Ansprüche 17 oder 18, **dadurch gekennzeichnet, dass** die Entkopplung der Antennen (4', 4") schaltungstechnisch erfolgt.

20. Anordnung nach einem der Ansprüche 17 bis 19, **dadurch gekennzeichnet, dass** ein Verstärkerelement (12, 14) jeweils zwischen den Antennen (4', 4") und dem Trennelement (10) angeordnet ist.

21. Verfahren zum Betrieb einer Anordnung nach einem der Ansprüche 1 bis 20, **dadurch gekennzeichnet,**
**dass** mehrere Sendesignale (S) und/oder mehrere Empfangssignale (E) von den Endgeräten bzw. für die Endgeräte (6) mittels eines gemeinsamen Koppelnetzwerks (2) gebündelt bzw. getrennt werden,
wobei zumindest ein Endgerät über einen bidirektionalen Kommunikationspfad mit dem Koppelnetzwerk in Verbindung steht und
wobei ein Trennelement diesen bidirektionalen Kommunikationspfad in im Koppelnetzwerk separat geführte Sende- und Empfangspfade aufspaltet und die Pfade der gemeinsamen abgesetzten Antennenanordnung (4, 4', 4'') zuführt.

## Claims

1. Arrangement for operating a plurality of terminals (6) on a common remote antenna arrangement (4, 4', 4'') with a coupling network (2) which comprises a first isolating element (8) associated with the antenna arrangement (4, 4', 4'') and a second isolating element (10) associated with the respective terminal (6),
**characterized**
**in that** the first isolating element (8) and the second isolating element (10) form a unit both functionally and physically and are functionally connected neither to the antenna (4) nor to one of the terminals (6),
and **in that** at least one of the isolating elements (10) is in a form such that an individual, bidirectional communication path leading from a terminal to the coupling network can be connected thereto, this isolating element splitting this bidirectional communication path into transmission and reception paths which are routed separately in the coupling network.

2. Arrangement according to Claim 1, **characterized in that** at least one of the terminals (6) is a bidirectionally operated terminal for sending and receiving information.

3. Arrangement according to either of Claims 1 and 2, **characterized in that** the coupling network (2) is arranged as an independent unit in the line between the antenna arrangement (4, 4', 4'') and the terminals (6).

4. Arrangement according to either of Claims 1 and 2, **characterized in that** the coupling network (2) is arranged as an independent unit in the antenna arrangement (4, 4', 4'').

5. Arrangement according to either of Claims 1 and 2, **characterized in that** the coupling network (2) is arranged as an independent unit in an appliance which is independent of the arrangement.

6. Arrangement according to one of Claims 1 to 5, **characterized in that** the coupling network (2) is integrated in one of the terminals (6), which has at least one additional output/input (A) for one or more further terminals (6).

7. Arrangement according to one of Claims 1 to 6, in which at least one amplifier element (12, 14) is provided for compensating for the losses.

8. Arrangement according to Claim 7, **characterized in that** at least one amplifier element (12, 14) is arranged between the first and the second isolating element (8, 10).

9. Arrangement according to either of Claims 7 and 8, **characterized in that** an amplifier element (12) is associated with the antenna arrangement (4, 4', 4'') at the reception end.

10. Arrangement according to one of Claims 7 to 9, in which all of the terminals (6) have a jointly associated amplifier element (14) at the transmission end.

11. Arrangement according to one of Claims 7 to 9, in which the terminals (6) have a respective associated amplifier element (14) at the transmission end.

12. Arrangement according to one of Claims 1 to 11, in which the isolating element (8, 10) provided is a circulator or a directional coupler.

13. Arrangement according to one of Claims 1 to 11, in which the isolating element (8, 10) provided is a filter, particularly a duplex filter.

14. Arrangement according to one of Claims 1 to 11, in which the isolating element (8, 10) provided is a switch (22).

15. Arrangement according to one of Claims 1 to 14, in which a divider (16) is provided at the reception end for splitting the received signals (E) over the terminals (6) and/or in which a summator (18) is provided at the transmission end for radiating the transmission signal (S).

16. Arrangement according to one of Claims 1 to 15, **characterized in that** the antenna arrangement is formed by a single, common transmission/reception antenna (4).

17. Arrangement according to one of Claims 1 to 15, **characterized in that** the antenna arrangement is formed by a common remote transmission antenna (4'') and at least one additional common remote reception antenna (4'), which is isolated from the common remote transmission antenna (4'').

18. Arrangement according to Claim 17, **characterized in that** the antennas (4', 4'') are provided at a physical distance apart, which means that the necessary damping between the transmission and reception paths is effected by the free-space damping between the antennas (4', 4'').

19. Arrangement according to either of Claims 17 and 18, **characterized in that** the antennas (4', 4'') are decoupled by means of circuitry.

20. Arrangement according to one of Claims 17 to 19, **characterized in that** an amplifier element (12, 14) is respectively arranged between the antennas (4', 4'') and the isolating element (10).

21. Method for operating an arrangement according to one of Claims 1 to 20, **characterized**
**in that** a plurality of transmission signals (S) and/or a plurality of received signals (E) from the terminals or for the terminals (6) are brought together or isolated using a common coupling network (2),
where at least one terminal is connected to the coupling network via a bidirectional communication path, and
where an isolating element splits this bidirectional communication path into transmission and reception paths routed separately in the coupling network and supplies the paths to the common remote antenna arrangement (4, 4', 4'').

## Revendications

1. Agencement pour faire fonctionner une pluralité de postes terminaux (6) sur un ensemble d'antenne commun distant (4, 4', 4''), avec un réseau de couplage (2) qui comprend un premier élément séparateur (8) associé à l'ensemble d'antenne (4, 4', 4'') et un deuxième élément séparateur (10) associé au poste terminal respectif (6),
**caractérisé en ce que** le premier élément séparateur (8) et le deuxième élément séparateur (10) forment une unité à la fois fonctionnellement et spatialement, et ne sont reliés fonctionnellement ni à l'antenne (4) ni à un des postes terminaux (6),
et **en ce qu'**au moins un des éléments séparateurs (10) est réalisé de telle sorte qu'on peut y raccorder une voie de communication bidirectionnelle individuelle menant d'un poste terminal au réseau de couplage, sachant que cet élément séparateur divise cette voie de communication bidirectionnelle en des voies d'émission et de réception dirigées séparément dans le réseau de couplage.

2. Agencement selon la revendication 1, **caractérisé en ce qu'**au moins un des postes terminaux (6) est un poste terminal à fonctionnement bidirectionnel pour l'émission et la réception d'informations.

3. Agencement selon la revendication 1 ou 2, **caractérisé en ce que** le réseau de couplage (2) est disposé sous la forme d'une unité indépendante dans la ligne entre l'ensemble d'antenne (4, 4', 4'') et les postes terminaux (6).

4. Agencement selon la revendication 1 ou 2, **caractérisé en ce que** le réseau de couplage (2) est disposé sous la forme d'une unité indépendante dans l'ensemble d'antenne (4, 4', 4'').

5. Agencement selon la revendication 1 ou 2, **caractérisé en ce que** le réseau de couplage (2) est disposé sous la forme d'une unité indépendante dans un appareil indépendant de l'agencement.

6. Agencement selon l'une quelconque des revendications 1 à 5, **caractérisé en ce que** le réseau de couplage (2) est intégré dans un des postes terminaux (6) qui présente au moins une entrée/sortie (A) supplémentaire pour un ou plusieurs autres postes terminaux (6).

7. Agencement selon l'une quelconque des revendications 1 à 6, dans lequel il est prévu au moins un élément amplificateur (12, 14) pour la compensation des pertes.

8. Agencement selon la revendication 7, **caractérisé en ce qu'**au moins un élément amplificateur (12, 14) est disposé entre le premier élément séparateur (8) et le deuxième élément séparateur (10).

9. Agencement selon la revendication 7 ou 8, **caractérisé en ce qu'**un élément amplificateur (12) est associé du côté de réception à l'ensemble d'antenne (4, 4', 4'').

10. Agencement selon l'une quelconque des revendications 7 à 9, **caractérisé en ce qu'**un élément amplificateur (14) est associé conjointement du côté d'émission à tous les postes terminaux (6).

11. Agencement selon l'une quelconque des revendications 7 à 9, **caractérisé en ce qu'**un élément amplificateur respectif (14) est associé du côté d'émission à chacun des postes terminaux (6).

12. Agencement selon l'une quelconque des revendications 1 à 11, dans lequel un circulateur ou un coupleur directif est prévu comme élément séparateur (8, 10).

13. Agencement selon l'une quelconque des revendications 1 à 11, dans lequel un filtre, notamment un filtre duplex, est prévu comme élément séparateur (8, 10).

14. Agencement selon l'une quelconque des revendications 1 à 11, dans lequel un commutateur (22) est prévu comme élément séparateur (8, 10).

15. Agencement selon l'une quelconque des revendications 1 à 14, dans lequel un diviseur (16) est prévu du côté de réception pour répartir les signaux de réception (E) sur les postes terminaux (6), et/ou dans lequel un élément additif (18) est prévu du côté d'émission pour émettre le signal d'émission (S).

16. Agencement selon l'une quelconque des revendications 1 à 15, **caractérisé en ce que** l'ensemble d'antenne est formé par une unique antenne commune d'émission/réception (4).

17. Agencement selon l'une quelconque des revendications 1 à 15, **caractérisé en ce que** l'ensemble d'antenne est formé par une antenne commune distante d'émission (4'') et au moins une antenne supplémentaire commune distante de réception (4'), séparée de l'antenne commune distante d'émission (4'').

18. Agencement selon la revendication 17, **caractérisé en ce que** les antennes (4', 4'') sont prévues spatialement distantes, de sorte que l'atténuation nécessaire entre la voie d'émission et la voie de réception s'effectue par l'atténuation en espace libre entre les antennes (4', 4'').

19. Agencement selon la revendication 17 ou 18, **caractérisé en ce que** le découplage des antennes (4', 4'') s'effectue par montage électrique.

20. Agencement selon l'une quelconque des revendications 17 à 19, **caractérisé en ce qu'**un élément amplificateur (12, 14) est respectivement disposé entre les antennes (4', 4'') et l'élément séparateur (10).

21. Procédé d'exploitation d'un agencement selon l'une quelconque des revendications 1 à 20, **caractérisé en ce que** plusieurs signaux d'émission (S) provenant des postes terminaux et/ou plusieurs signaux de réception (E) destinés aux postes terminaux (6) sont regroupés ou séparés au moyen d'un réseau de couplage commun (2),
sachant qu'au moins un poste terminal est relié au réseau de couplage par l'intermédiaire d'une voie de communication bidirectionnelle,
et sachant qu'un élément séparateur divise cette voie de communication bidirectionnelle en des voies d'émission et de réception dirigées séparément dans le réseau de couplage, et apporte les voies à l'ensemble d'antenne commun distant (4, 4', 4'').
